# EUROPEAN PATENT APPLICATION

(11) **EP 2 980 836 A1**
(43) Date of publication of application: **03.02.2016**
(21) Application number: 14776104.3
(22) Date of filing: 13.03.2014
(51) Int. Cl.: H01L 21/56, H01L 33/52

(54) **METHOD FOR MANUFACTURING OPTICAL SEMICONDUCTOR DEVICE, SYSTEM, MANUFACTURING CONDITIONS DETERMINATION DEVICE, AND MANUFACTURING MANAGEMENT DEVICE**

(30) Priority: 28.03.2013 JP 2013069496; 04.12.2013 JP 2013251346
(71) Applicant: Nitto Denko Corporation, Ibaraki-shi, Osaka 567-8680 (JP)
(72) Inventor: KATAYAMA, Hiroyuki, Ibaraki-shi Osaka 567-8680 (JP); ITO, Hisataka, Ibaraki-shi Osaka 567-8680 (JP); MITANI, Munehisa, Ibaraki-shi Osaka 567-8680 (JP)
(74) Representative: Hoffmann Eitle
(86) International application number: PCT/JP2014/056750
(87) International publication number: WO 2014/156696

(57) **Abstract**

A method for producing an optical semiconductor device including a varnish production step of producing a varnish containing particles and a curable resin, a cover layer production step of producing an A-stage cover layer from the varnish, and a covering step of covering the optical semiconductor element with the A-stage covering layer.

## Description

### TECHNICAL FIELD

The present invention relates to a method and a system for producing an optical semiconductor device, a production condition determination device, and a production management device. In particular, the present invention relates to a method for producing an optical semiconductor device, a system that determines and manages the production conditions, a production condition determination device, and a production management device.

### BACKGROUND ART

Conventionally, as a method for producing an optical semiconductor device, the following method is known: first, an uncured curable resin composition containing particles and a curable resin is prepared, and thereafter, a package in which a light emitting diode is mounted is potted with the composition, and thereafter, the curable resin composition is cured (e.g., Patent Document 1).

Patent Document 2 has proposed an alternative method, in which an A-stage varnish containing particles and a curable resin is prepared; thereafter, the varnish is applied on a release sheet and thereafter, brought into B-stage; thereafter, the B-stage sheet covers a light emitting diode mounted on the board; and thereafter, the B-stage sheet is brought into C-stage.

### Citation List

### Patent Document

Patent Document 1: Japanese Unexamined Patent Publication No. 2007-332314
Patent Document 2: Japanese Unexamined Patent Publication No. 2013-140848

### SUMMARY OF THE INVENTION

### PROBLEM TO BE SOLVED BY THE INVENTION

However, the method of Patent Document 1 may be disadvantageous in that an uneven thickness of the cured layer of the curable resin composition is easily caused, and therefore, luminosity of the optical semiconductor device may be reduced.

Meanwhile, the method of Patent Document 2 needs a step for preparing a B-stage sheet from an A-stage varnish, and therefore, a large man-hour is needed and is troublesome. Thus, it is disadvantageous in that improvement in production efficiency of a method for producing an optical semiconductor device is not easily caused.

An object of the present invention is to provide a method for producing an optical semiconductor device, in which a cover layer can be prepared with an even thickness, excellent luminosity, reduced man-hour, and improved production efficiency; a system for determining and managing the production conditions; a production condition determination device; and a production management device.

### MEANS FOR SOLVING THE PROBLEM

A method for producing an optical semiconductor device of the present invention includes a varnish production step of producing a varnish containing particles and a curable resin; a cover layer production step of producing an A-stage cover layer from the varnish; and a covering step of covering the optical semiconductor element with the A-stage covering layer.

With this method, the optical semiconductor element is covered with the A-stage covering layer, and therefore man-hour for preparing a B-stage sheet as in Patent Document 2 can be reduced. Therefore, man-hour can be reduced, and production efficiency of the optical semiconductor device can be improved.

Furthermore, with this method, after producing an A-stage cover layer from a varnish, the optical semiconductor element is covered with the A-stage covering layer: therefore, compared with potting as in Patent Document 1, the cover layer can be prepared with an even thickness. Therefore, an optical semiconductor device with excellent luminosity can be produced.

Thus, with this method, an optical semiconductor device with excellent luminosity can be produced at low costs.

A system of the present invention is a system for determining and managing a production condition for the cover layer production step in the above-described method for producing an optical semiconductor device, wherein the system includes a production condition determination device and a production management device, the production condition determination device including a first information storage region in which first information relating to an optical semiconductor element and an optical semiconductor device is stored, a second information storage region in which second information relating to a varnish is stored, and a determination means that determines the production condition based on the first information stored in the first information storage region and the second information stored in the second information storage region, and the production management device including a third information storage region in which third information relating to the production conditions determined by the determination means is stored, and a management means for managing the production condition for the cover layer production step based on the third information stored in the third information storage region.

In the system, the production condition determination device includes the first information storage region, the second information storage region, and the determination means, while the production management device includes the third information storage region and the management means.

In the production condition determination device, the first information and the second information are stored in the first information storage region and the second information storage region, respectively, and the production conditions for the cover layer production step can be determined by the determination means, and the production conditions can be provided to the production management device.

In the production management device, the third information relating to the production conditions provided from the production condition determination device is stored in the third information storage region, and based on the third information, the management means manages the production conditions for the cover layer production step.

Therefore, the production conditions for the cover layer production step can be determined in the production condition determination device separately from the production management device, and can be managed by the production management device.

The third information relating to the production conditions for the cover layer production step provided from the production condition determination device is based on the first information and the second information. Therefore, in the production management device, the management means can precisely manage the production conditions for the cover layer production step based on the third information provided from the production condition determination device. Thus, precise production of a target optical semiconductor device can be achieved.

It is preferable that the system of the present invention further determines and manages a production condition for the varnish production step, and the determination means further determines the production condition for the varnish production step based on the first information stored in the first information storage region and the second information stored in the second information storage region, and the management means further manages the production condition for the varnish production step based on the third information stored in the third information storage region.

In the system, the determination means further determines the production conditions for the varnish production step based on the first information stored in the first information storage region and the second information stored in the second information storage region, and the management means further manages the production conditions for the varnish production step based on the third information stored in the third information storage region. Therefore, highly precise production of a cover layer compatible with a target optical semiconductor device can be achieved, and furthermore, highly precise production of a target optical semiconductor device can be achieved.

In the system of the present invention, it is preferable that the first information contains information relating to a board on which an optical semiconductor element is mounted.

With the system, the first information contains the information relating to a board on which an optical semiconductor element is mounted, and therefore the production condition determination device can also include the information relating to a board on which an optical semiconductor element is mounted along with the above-described information.

Therefore, based on the highly precise third information relating to production conditions determined based on the first information, the production management device can more precisely manage the production conditions for the cover layer production step.

In the system of the present invention, it is preferable that the production management device includes a fourth information storage region in which fourth information is stored, the fourth information containing lot information of at least one of particles, a curable resin, a varnish, and an optical semiconductor element, and/or a production amount of the optical semiconductor device per unit period, and a modification means that modifies the production condition for the cover layer production step based on the fourth information stored in the fourth information storage region.

The lot information of particles, a curable resin, a varnish, and an optical semiconductor element changes in every lot. Furthermore, the production amount of the optical semiconductor device per unit period changes in every unit of time. Therefore, in every lot and/or unit of time, the physical properties of the optical semiconductor device to be produced may change. In such a case, it is troublesome for the production condition determination device to determine the production conditions based on the fourth information every time.

However, in the system, in the production management device, the modification means can modify the production conditions for the cover layer production step based on the fourth information containing lot information of at least one of particles, a curable resin, a varnish, and an optical semiconductor element and/or a production amount of the optical semiconductor device per unit period stored in the fourth information storage region. Therefore, easily responding to the changes in the lot information and/or production amount of the optical semiconductor device, production conditions for the cover layer production step can be modified, and precise production of a target optical semiconductor device can be achieved.

In the system of the present invention, it is preferable that the production condition determination device includes a fifth information storage region in which fifth information relating to production conditions for previous production of the cover layer is stored, and determines the production condition for current production of the cover layer based on the fifth information stored in the fifth information storage region.

With the system, the production condition determination device can accumulate the fifth information relating to production conditions for previous production of the cover layer. Therefore, based on the previously accumulated production conditions, a cover layer suitable for a target optical semiconductor device can be currently produced, and furthermore, precise production of a target optical semiconductor device can be currently achieved.

In the system of the present invention, it is preferable that the production condition determination device remotely communicates with the production management device through a network.

With the system, the production condition determination device remotely communicates with the production management device through a network, and therefore even if the production condition determination device is remotely located from the production management device, the production conditions for the cover layer production step determined in the production condition determination device can be quickly provided to the production management device.

In the system of the present invention, it is preferable that the production management device is provided in a cover layer production factory, and the production condition determination device is provided in a control section located far from the cover layer production factory.

With the system, even if the production management device is provided in the cover layer production factory and the production condition determination device is provided in the control section located far from the cover layer production factory, the production condition determination device remotely communicates with the production management device through a network, and therefore the production conditions for the cover layer production step determined by the production condition determination device in the control section can be quickly provided to the production management device.

A production condition determination device of the present invention is a production condition determination device for determining the production conditions for the cover layer production step in the above-described method for producing an optical semiconductor device, and includes a first information storage region in which the first information relating to an optical semiconductor element is stored, a second information storage region in which second information relating to a varnish is stored, and a determination means that determines the production condition based on the first information stored in the first information storage region and the second information stored in the second information storage region.

The production condition determination device includes the first information storage region, the second information storage region, and the determination means.

Therefore, with the production condition determination device, the first information and the second information can be stored in the first information storage region and the second information storage region, respectively, and the determination means can determine the production conditions for the cover layer production step.

Thus, based on the production conditions for the cover layer production step, precise production of a target optical semiconductor device can be achieved.

It is preferable that the production condition determination device of the present invention further determines the production conditions for the varnish production step, and the determination means further determines the production conditions for the varnish production step based on the first information stored in the first information storage region and the second information stored in the second information storage region.

In the production condition determination device, the determination means further determines the production conditions for the varnish production step based on the first information stored in the first information storage region and the second information stored in the second information storage region. Therefore, highly precise production of a cover layer compatible with a target optical semiconductor device can be achieved, and furthermore, highly precise production of a target optical semiconductor device can be achieved.

In the production condition determination device of the present invention, it is preferable that the first information contains the information relating to a board on which an optical semiconductor element is mounted.

In the production condition determination device, the first information contains the information relating to a board on which an optical semiconductor element is mounted, and therefore the production condition determination device can also contain the information relating to a board on which an optical semiconductor element is mounted along with the above-described information.

Therefore, a highly precise production of a target optical semiconductor device can be achieved.

It is preferable that the production condition determination device of the present invention includes a fifth information storage region in which fifth information relating to production conditions for previous production of the cover layer is stored, and determines the production conditions for current production of the cover layer based on the fifth information stored in the fifth information storage region.

With the production condition determination device, the fifth information relating to production conditions for the cover layer in the previous production can be accumulated. Therefore, based on the previously accumulated production conditions, a cover layer suitable for a target optical semiconductor device can be currently produced, and furthermore, precise production of a target optical semiconductor device can be currently achieved.

A production management device of the present invention is a production management device for managing a production condition for the cover layer production step in the above-described method for producing an optical semiconductor device, and includes a third information storage region in which third information relating to the production conditions is stored, and a management means that manages the production condition for the cover layer production step based on the third information stored in the third information storage region.

In the production management device, the third information relating to the production conditions for the cover layer production step in the above-described optical semiconductor device is stored in the third information storage region, and the management means precisely manages the production conditions for the cover layer production step based on the third information.

Therefore, precise production of a target optical semiconductor device can be achieved.

It is preferable that the production management device of the present invention further manages the production condition for the varnish production step, and the management means further manages the production condition for the varnish production step based on the third information stored in the third information storage region.

In the production management device, the management means further manages the production conditions for the varnish production step based on the third information stored in the third information storage region, and therefore highly precise production of a cover layer compatible with a target optical semiconductor device can be achieved, and furthermore, highly precise production of a target optical semiconductor device can be achieved.

It is preferable that the production management device of the present invention includes a fourth information storage region in which the fourth information including lot information of at least one of particles, a curable resin, a varnish, and an optical semiconductor element, and/or a production amount of the optical semiconductor device per unit period is stored, and a modification means that modifies the production condition for the cover layer production step based on the fourth information stored in the fourth information storage region.

The lot information of particles, a curable resin, a varnish, and an optical semiconductor element changes in every lot. Furthermore, the production amount of the optical semiconductor device per unit period changes in every unit of time. Therefore, the physical properties of the optical semiconductor device to be produced may change in every lot and/or unit of time. In such a case, it is troublesome for the production condition determination device to determine the production conditions based on the fourth information every time.

However, with the production management device, the modification means can modify the production conditions for the cover layer production step based on the fourth information containing lot information of at least one of particles, a curable resin, a varnish, and an optical semiconductor element, and/or a production amount of the optical semiconductor device per unit period stored in the fourth information storage region. Therefore, easily responding to the changes in the lot information and/or production amount of the optical semiconductor device, production conditions for the cover layer production step can be modified, and precise production of a target optical semiconductor device can be achieved.

### EFFECT OF THE INVENTION

With the method for producing an optical semiconductor device of the present invention, an optical semiconductor device with excellent luminosity can be produced at low costs.

With the system of the present invention including the production condition determination device and the production management device of the present invention, the production condition determination device can make determinations separately from the production management device, and the production management device can perform managing. Furthermore, precise production of a target optical semiconductor device can be achieved.

### BRIEF DESCRIPTION OF THE DRAWINGS

FIG. 1A-FIG. 1C are process drawings of an embodiment of the method for producing an optical semiconductor device of the present invention, FIG. 1A illustrating a step in which a board on which optical semiconductor elements are mounted, and a release sheet provided with a cover layer are placed in a lamination device; FIG. 1B illustrating a step in which the board and the cover layer are laminated; and FIG. 1C illustrating a step in which the release sheet is removed.
FIG. 2 shows a schematic diagram illustrating the configuration of an embodiment of the system of the present invention.
FIG. 3 shows a schematic diagram illustrating the configuration of a variation of the system of FIG. 2.

### DESCRIPTION OF EMBODIMENTS

An embodiment of the method for producing an optical semiconductor device of the present invention includes a varnish production step of producing a varnish containing particles and a curable resin, a cover layer production step of producing an A-stage cover layer from the varnish, and a covering step of covering the optical semiconductor element with the A-stage covering layer. In the following, each of the steps is described.

### <Varnish production step>

Examples of the particles include a phosphor and a filler.

The phosphor has a wavelength conversion function. Examples thereof include a yellow phosphor that is capable of converting blue light into yellow light, and a red phosphor that is capable of converting blue light into red light.

Examples of the yellow phosphor include a silicate phosphor such as (Ba,Sr,Ca)₂SiO₄; Eu, (Sr,Ba)₂SiO₄:Eu (barium orthosilicate (BOS)); a garnet type phosphor having a garnet type crystal structure such as Y₃Al₅O₁₂:Ce (YAG (yttrium • aluminum • garnet):Ce), Tb₃Al₃O₁₂:Ce (TAG (terbium • aluminum • garnet):Ce); and an oxynitride phosphor such as Ca-α-SiAlON.

Examples of the red phosphor include a nitride phosphor such as CaAlSiN₃:Eu and CaSiN₂:Eu.

Examples of the shape of the phosphor include a sphere shape, a plate shape, and a needle shape.

The average value of the maximum length (when spherical, the average particle size) of the phosphor is, for example, 0.1 µm or more, preferably 1 µm or more, and for example, 200 µm or less, preferably 100 µm or less.

The absorption peak wavelength of the phosphor is, for example, 300 nm or more, preferably 430 nm or more, and, for example, 550 nm or less, preferably 470 nm or less.

The phosphor may be used singly, or may be used in combination.

The mixing ratio of the phosphor relative to 100 parts by mass of the curable resin is, for example, 0.1 parts by mass or more, preferably 0.5 parts by mass or more, and for example, 80 parts by mass or less, preferably 50 parts by mass or less.

Examples of the filler include organic microparticles such as silicone particles (to be specific, including silicone rubber particles), and inorganic microparticles such as silica (e.g. fumed silica, etc.), talc, alumina, aluminum nitride, and silicon nitride. The average value of the maximum length (when spherical, the average particle size) of the filler is, for example, 0.1 µm or more, preferably 1 µm or more, and for example, 200 µm or less, preferably 100 µm or less. The filler may be used singly, or may be used in combination. The mixing ratio of the filler relative to 100 parts by mass of the curable resin is, 0.1 parts by mass or more, preferably 0.5 parts by mass or more, and, for example, 70 parts by mass or less, preferably 50 parts by mass or less.

Examples of the curable resin include one-step curable resin.

The one-step curable resin has a one step reaction scheme: the resin is completely cured in the reaction of the one step. Examples of the one-step curable resin include a one-step curable thermosetting resin that is cured by heat, and a one-step curable activation energy-ray curable resin that is cured by application of activation energy-ray (e.g. ultraviolet ray, electron beam, etc.). Preferably, the one-step curable thermosetting resin is used.

To be specific, examples of the one-step curable thermosetting resin include silicone resin, epoxy resin, polyimide resin, phenol resin, urea resin, melamine resin, and unsaturated polyester resin. Preferably, in view of translucency and durability, a one-step curable silicone resin is used.

The one-step curable resin in A stage has a viscosity of, for example, 1,000 mPa • s or more, preferably 3,000 mPa • s or more, more preferably 5,000 mPa • s or more, and for example, 1,000,000 mPa • s or less, preferably 500,000 mPa • s or less, more preferably 200,000 mPa • s or less. The viscosity of the one-step curable resin in A stage is measured by setting the temperature of the A stage one-step curable resin to 25°C, and using a type E cone at a number of revolution of 99s⁻¹. The viscosity discussed below is measured in accordance with the above-described method.

The mixing ratio of the curable resin is, relative to the varnish (hereinafter may also be referred to as particle-containing curable resin composition.), for example, 30 mass% or more, preferably 40 mass% or more, more preferably 50 mass% or more, and for example, 98 mass% or less, preferably 95 mass% or less, more preferably 90 mass% or less.

The particle-containing curable resin composition can also contain, as necessary, a solvent.

Examples of the solvent include aliphatic hydrocarbon such as hexane, aromatic hydrocarbon such as xylene, and siloxanes such as vinylmethyl cyclic siloxane, and both-end terminated vinyl polydimethyl siloxane. The solvent is blended in the particle-containing curable resin composition at a mixing ratio such that the particle-containing curable resin composition achieves the viscosity described later.

To prepare the particle-containing curable resin composition, the blending is conducted based on the desired types of the particles, mixing ratio of the particles, average value of the maximum length of the particles, types of the curable resin, viscosity of the curable resin, and mixing ratio of the curable resin, and when the particles contain phosphor, based on the absorption peak wavelength of the phosphor and viscosity of the varnish. Then, the mixture is blended using, for example, a mixer.

In this manner, the A-stage varnish is prepared.

That is, the varnish contains the A-stage curable resin, and therefore referred to as an A-stage varnish.

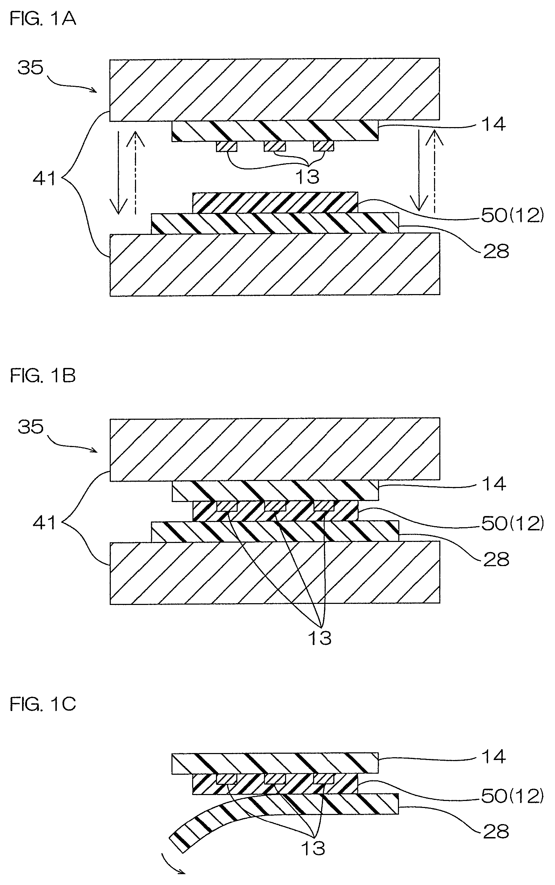

The viscosity of the varnish at 25°C and under 1 atmospheric pressure is set so that the varnish does not fall off from the peripheral end portion of the upper face of the release sheet 28 (described later, ref: FIG. 1A). To be specific, for example, 1,000 mPa • s or more, preferably 4,000 mPa • s or more, more preferably 8,000 mPa • s or more, and for example, 1,000,000 mPa • s or less, preferably 500,000 mPa • s or less, more preferably 200,000 mPa • s or less.

### <Cover layer production step>

To produce an A-stage cover layer from the varnish, as shown in FIG. 1A, for example, first, the varnish is applied to the surface of the release sheet 28.

Examples of the release sheet 28 include polymer films such as a polyethylene film and a polyester film (PET, etc.), a ceramic sheet, and a metal foil. Preferably, a polymer film is used. The surface of the release sheet 28 can also be treated with fluorine for releasing.

To apply the varnish to the surface of the release sheet 28, for example, application devices such as a dispenser, applicator, and slit die coater are used, and preferably, a dispenser is used.

The A-stage cover layer 50 thus applied has a thickness of, for example, 10 µm or more, preferably 50 µm or more, and for example, 2,000 µm or less, preferably 1,000 µm or less.

When the varnish contains a solvent, the applied cover layer 50 can also be heated. The heating conditions can be the conditions that substantially do not accelerate the curing reaction of the curable resin: to be specific, a temperature of, for example, 40°C or more, preferably 60°C or more, and for example, 150°C or less, preferably 130°C or less. The heating time is, for example, 1 minute or more, preferably 5 minutes or more, and for example, 60 minutes or less, preferably 40 minutes or less.

### <Covering step>

To cover the optical semiconductor element 13 with the A-stage cover layer 50, for example, first, as shown in FIG. 1A, a board 14 on which the optical semiconductor elements 13 are mounted is prepared.

Examples of the board 14 include, for example, an insulating board including a laminate board in which an insulating layer is laminated on, for example, a silicon board, ceramic board, polyimide resin board, and metal board. The outline shape of the board 14 is not particularly limited, and for example, the shape is a generally rectangular shape or a generally circular shape when viewed from the top. The size of the board 14 is suitably set, and for example, the maximum length is, for example, 2 mm or more, preferably 10 mm or more, and for example, 300 mm or less, preferably 100 mm or less.

On the surface of the board 14, a conductive pattern (not shown) including an electrode (not shown) to be electrically connected with a terminal (not shown) of the optical semiconductor element 13 and wires continuous therefrom, to be described next, is formed. The conductive pattern can be a conductor of, for example, gold, copper, silver, and nickel.

The surface of the board 14 is formed to be flat. Alternatively, although not shown, the surface (lower face in FIG. 1A-FIG. 1C) on which the optical semiconductor elements 13 are mounted of the board 14 can be formed with depressed portions that are depressed towards the back face (upper face in FIG. 1A-FIG. 1C).

The optical semiconductor element 13 is, for example, an LED (light-emitting diode element) that converts electric energy into light energy, and LD (laser diode), and for example, the shape can be a generally rectangular shape viewed in cross section having a thickness shorter than the surface direction length (length in a direction perpendicular to the thickness direction). For the optical semiconductor element 13, preferably, a blue LED that emits blue light is used. The size of the optical semiconductor element 13 is set in accordance with use and purpose, and to be specific, the thickness is, for example, 10 µm or more and 1000 µm or less, the maximum length is, for example, 0.05 mm or more, preferably 0.1 mm or more, and for example, 5 mm or less, preferably 2 mm or less.

The emission peak wavelength of the optical semiconductor element 13 is, for example, 400 nm or more, preferably 430 nm or more, and for example, 500 nm or less, preferably 470 nm or less.

The optical semiconductor element 13 is, for example, flip chip mounted, or connected by wire bonding on the board 14.

A plurality of the optical semiconductor elements 13 can be mounted on one board 14 (three in FIG. 1A-FIG. 1C). The number of the optical semiconductor element 13 per one board 14 is, for example, 1 or more, preferably 4 or more, and for example, 2000 or less, preferably 400 or less.

Next, in this method, the board 14 on which the optical semiconductor elements 13 are mounted is placed on a lamination device 35. The lamination device 35 includes two flat plates 41 disposed to face each other in up-down direction in spaced-apart relation, and are capable of moving the lamination device 35 and the board 14 in up-down directions.

To place the board 14 on which the optical semiconductor elements 13 are mounted in the lamination device 35, to be specific, the board 14 is placed on the flat plate 41 on the lower side so that the optical semiconductor elements 13 face downward.

Separately, the cover layer 50 provided on the upper face of the release sheet 28 is placed below the optical semiconductor elements 13 to face thereto. That is, the release sheet 28 is placed on the upper face of the flat plate 41 of the lower side so that the cover layer 50 faces the optical semiconductor elements 13 (that is, lower side).

Then, as shown in FIG. 1B, the optical semiconductor elements 13 are covered with the cover layer 50. The optical semiconductor elements 13 are embedded in the cover layer 50. To be specific, the board 14 and the cover layer 50 are laminated so that they are adjacent to each other by the lamination device 35. To be specific, as shown in the arrows in FIG. 1A and FIG. 1B, the board 14 on which the optical semiconductor elements 13 are mounted is descended (pressed down) to the release sheet 28 on which the cover layer 50 is provided. That is, the upper-side flat plate 41 is descended. Alternatively, as shown in the phantom line arrow in FIG. 1A and FIG. 1B, the release sheet 28 on which the cover layer 50 is provided is ascended (pushed up) toward the board 14 on which the optical semiconductor elements 13 are mounted. That is, the lower-side flat plate 41 is descended.

In this manner, the optical semiconductor elements 13 are covered with the cover layer 50. That is, the optical semiconductor element 13 is embedded in the cover layer 50.

Thereafter, the A-stage cover layer 50 is brought into C-stage (completely cured).

For example, when the curable resin is a thermosetting resin, the cover layer 50 that is in A-stage is heated.

To be specific, it is introduced into an oven (not shown) while the cover layer 50 is sandwiched by the lamination device 35. In this manner, the cover layer 50 in A-stage is heated.

The heating temperature is, for example, 80°C or more, preferably 100°C or more, and, for example, 200°C or less, preferably 180°C or less. The heating time is, for example, 10 minutes or more, preferably 30 minutes or more, and, for example, 10 hours or less, preferably 5 hours or less.

The heating of the cover layer 50 brings the stage of the cover layer 50 from A-stage to C-stage (completely cured).

Meanwhile, when the curable resin is an activation energy-ray curable resin, the cover layer 50 is irradiated with an active energy ray. In this manner, the stage of the cover layer 50 is brought from A-stage to C-stage (completely cured). To be specific, the cover layer 50 in A-stage is irradiated with ultraviolet ray using, for example, an ultraviolet ray lamp.

In this manner, the optical semiconductor device 20 including the cover layer 50, the optical semiconductor elements 13 encapsulated with the cover layer 50, and the board 14 on which the optical semiconductor elements 13 are mounted is produced.

In FIG. 1B, a plurality of (three) optical semiconductor elements 13 are provided in one optical semiconductor device 20.

Thereafter, as shown in FIG. 1C, the release sheet 28 is removed, as shown in the arrow, from the cover layer 50.

Thereafter, as necessary, when the plurality of the optical semiconductor elements 13 are mounted on one board 14, the cover layer 50 can be cut into individual pieces correspondingly to one optical semiconductor element 13.

### [Operations and effects of method for producing optical semiconductor device]

With the method, the A-stage cover layer 50 covers the optical semiconductor element 13, and therefore man-hours for preparing the B-stage sheet as in Patent Document 2 can be reduced. Thus, man-hours can be reduced, and production efficiency of the production condition determination device 20 can be improved.

Furthermore, with the method, after producing the A-stage cover layer 50 from varnish, the A-stage cover layer 50 covers the optical semiconductor element 13, and therefore compared with the case where potting is performed as in Patent Document 1, the cover layer 50 can be prepared with a more homogeneous thickness. Thus, an optical semiconductor device 20 having excellent luminosity can be produced.

Thus, with the method, an optical semiconductor device 20 having excellent luminosity can be produced at low costs.

### [Variation]

In the covering step of FIG. 1B, the sheet-type cover layer 50 and release sheet 28 are laminated on the board 14 on which the optical semiconductor elements 13 are mounted using the lamination device 35 including the two flat plates 41. However, for example, although not shown, elongated cover layer 50 and release sheet 28 can be continuously laminated on the board 14 on which the plurality of optical semiconductor elements 13 are mounted using a roll device.

With the method, production efficiency of the optical semiconductor device 20 can be further improved.

### [System configuration]

Next, description is given below of a system for determining and managing production conditions for the cover layer production step of the method for producing the above-described optical semiconductor device 20.

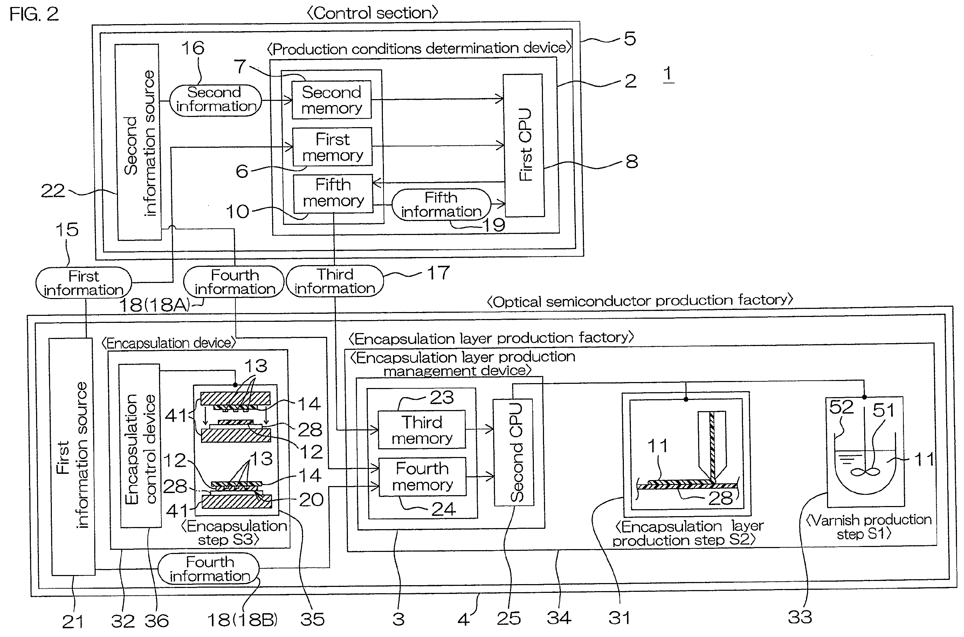

As shown in FIG. 2, the system 1 is a system provided for a control section 5 of an encapsulating layer production factory and an optical semiconductor device production factory 4 that is separately provided from the encapsulating layer production factory. The system 1 determines and manages production conditions for a varnish production step S1 and an encapsulating layer production step S2, out of a method for producing an optical semiconductor device 20 including a varnish production step S1 in which a varnish 11 containing particles and a curable resin is produced, an encapsulating layer production step S2 (an example of a cover layer production step) in which an encapsulating layer 12 as an example of the A-stage cover layer is produced from the varnish 11, and an encapsulation step S3 (an example of a covering step) in which the optical semiconductor element 13 is encapsulated with the encapsulating layer 12. The system 1 includes a production condition determination device 2, and an encapsulating layer production management device 3 as a production management device.

The control section 5 is provided, for example, in an encapsulating layer production factory, in which an encapsulating layer 12 similar to the encapsulating layer 12 produced with the encapsulating layer production device 34 (described later) of the optical semiconductor device production factory 4 can be produced.

The control section 5 includes a production condition determination device 2.

The production condition determination device 2 includes a first memory 6 as a first information storage region, a second memory 7 as a second information storage region, a first CPU 8 as a determination means, and a fifth memory 10 as a fifth information storage region.

The first memory 6 stores first information 15 relating to the optical semiconductor element 13, the board 14 on which the optical semiconductor element 13 is mounted, and the optical semiconductor device 20.

The first information 15 includes, to be specific, as information relating to the optical semiconductor element 13, for example, the shape of the optical semiconductor element 13, the size of the optical semiconductor element 13, the emission peak wavelength of the optical semiconductor element 13, the number of the optical semiconductor elements 13 mounted per unit area of the board 14, and the number of the optical semiconductor element 13 mounted per one board 14.

Examples of the first information 15 include, to be specific, as information relating to the board 14, for example, the outline shape of the board 14, the size of the board 14, and the surface shape of the board 14 (presence or absence of unevenness, etc.).

Furthermore, the first information 15 include, to be specific, as information relating to the optical semiconductor device 20, for example, color temperature of the optical semiconductor device 20, total luminous flux of the optical semiconductor device 20, and luminous characteristics of the optical semiconductor device 20. To be specific, the target color temperature is, when the target light color is daylight white, for example, 4600K or more, and for example, 5500K or less. The target color temperature is, when the target light color is warm white, for example, 3250K or more, and for example, 3800K or less. The target color temperature is selected from the above-described temperature range.

The first memory 6 is configured such that the input is through a first information source 21 of the optical semiconductor device production factory 4.

The second memory 7 stores second information 16 relating to the varnish 11.

Examples of the second information 16 include, to be specific, as information relating to the particles, for example, the types of the particles, the mixing ratio of the particles, and the average value of the maximum length (when the particles are spherical, the average particle size) of the particles. When the particles contain the above-described phosphor, as information relating to the particles, the absorption peak wavelength of the phosphor is also included. The second information 16 includes, to be specific, as information relating to the curable resin, for example, the types of the curable resin, the viscosity of the curable resin, the mixing ratio of the curable resin, and the curing speed of the curable resin. The second information 16 further includes, to be specific, as information relating to the varnish, for example, the viscosity of the varnish. Furthermore, the second information 16 includes, when the above-described release sheet 28 is provided with a positioning mark (not shown), information regarding relative positions of the plurality of varnishes 11 after application.

The second information 16 is inputted through the second information source 22 of the control section 5 of the encapsulating layer production factory.

The first CPU 8 is a determination device that determines production conditions for the encapsulating layer 12 based on the first information 15 stored in the first memory 6 and the second information 16 stored in the second memory 7.

The first CPU 8 prestores predetermined programmed processing, and the first CPU 8 determines the production conditions for the encapsulating layer 12 based on the programmed processing.

The production conditions for the encapsulating layer 12 include, for example, application conditions for the varnish 11. When the varnish contains a solvent, heating conditions at the time of drying the varnish by heating are also included.

The application conditions for the varnish 11 include, for example, the shape of the varnish 11 immediately after the application, and the thickness of the varnish 11 immediately after the application. The above-described shape includes the shape where the varnishes 11 are spaced apart from each other.

The first CPU 8 is configured such that the first information 15 stored in the first memory 6 and the second information 16 stored in the second memory 7 can be read.

The fifth memory 10 is a region that stores production conditions for the encapsulating layer 12 determined by the first CPU 8.

The fifth memory 10 is provided with a recording region (not shown) capable of recording fifth information 19 relating to the production conditions for previous productions of the encapsulating layer 12. The fifth information 19 that is recorded and accumulated in the recording region is read by the first CPU 8 in the current production, and then again, the first CPU 8 determines the production conditions for the encapsulating layer 12.

The optical semiconductor device production factory 4 includes an encapsulating layer production device 34 and an encapsulation device 32.

The encapsulating layer production device 34 includes a varnish production device 33, an application device 31, and an encapsulating layer production management device 3.

The varnish production device 33 includes, for example, a vessel 52 equipped with a mixer 51.

The application device 31 includes, for example, a dispenser, an applicator, and a slit die coater. The application device 31 can also include, although not shown, an oven having heaters disposed in spaced-apart relation.

The encapsulating layer production management device 3 includes a third memory 23 as a third information storage region, a fourth memory 24 as a fourth information storage region, and a second CPU 25 as a modification means, which is a management means.

The third memory 23 stores third information 17 relating to production conditions for the encapsulating layer 12 determined by the first CPU 8.

The third information 17 includes production conditions for the encapsulating layer 12 determined by the first CPU 8.

The third memory 23 is configured such that the third information 17 determined at the fifth memory 10 is inputted through the fifth memory 10.

The fourth memory 24 stores fourth information 18 including lot information of at least one of particles, a curable resin, a varnish, and an optical semiconductor element 13, and/or a production amount of the optical semiconductor device 20 per unit period.

The lot information is information that changes in accordance with the changes in the lot. To be specific, the lot information include the average value of the maximum length (when the particles are spherical, average particle size) of particles that is different depending on the lot, and the viscosity of a curable resin that is different depending on the lot. When the particles contain a phosphor, as the lot information of the phosphor, the absorption peak wavelength of the phosphor that is different depending on the lot is included. Furthermore, the information relating to the varnish that is different depending on the lot includes the viscosity of the varnish derived from the particles and/or curable resins of different lot as described above.

The amount of the production of the optical semiconductor device 20 per unit period is, as a production amount of the optical semiconductor device 20 per one month, for example, selected from the range of 1,000 or more, preferably 5,000 or more, and for example, 200,000 or less.

The fourth memory 24 is configured such that the fourth information 18 is inputted through the first information source 21 of the optical semiconductor device production factory 4, and the second information source 22 of the control section 5.

Of the fourth information 18, examples of the fourth information 18B inputted through the first information source 21 include, for example, lot information of the optical semiconductor element 13, the production amount of the optical semiconductor device 20 per unit period, and furthermore, as the fourth information 18A inputted through the second information source 22, for example, lot information of the particles, lot information of the curable resin, and lot information of the varnish are included.

The second CPU 25 prestores predetermined programmed processing, and the second CPU 25 manages the production conditions for the varnish production step S1, and the production conditions for the encapsulating layer production step S2 based on the third information 17 stored in the third memory 23. Furthermore, the second CPU 25 can also modify the production conditions for the varnish production step S 1 and the production conditions for the encapsulating layer production step S2 based on the fourth information 18 stored in the fourth memory 24.

The second CPU 25 is configured such that the third information 17 stored in the third memory 23, and the fourth information 18 stored in the fourth memory 24 can be read.

The second CPU 25 is configured such that the production conditions for the varnish production step S 1 and the production conditions for the encapsulating layer production step S2 can be managed and modified in the varnish production device 33 and the application device 31, respectively.

The encapsulation device 32 includes the lamination device 35 and the encapsulation control device 36.

For the lamination device 35, for example, a lamination device having two flat plates 41 disposed to face each other in spaced-apart relation in up-down directions and are capable of moving the encapsulating layer 12 and the board 14 in up-down directions is selected.

The encapsulation control device 36 is configured such that the encapsulation conditions for the encapsulation step S3 can be controlled. The encapsulation control device 36 includes a memory which is not shown, and configured such that the encapsulation conditions for the encapsulation step S3 are inputted through the first information source 21, to control the encapsulation conditions for the encapsulation step S3.

Next, description is given below of a method for producing an optical semiconductor device 20 in the optical semiconductor device production factory 4 using the system 1.

### 1. Production conditions determination step

In this method, first, the first information 15 is inputted from the first information source 21 into the first memory 6. To input the first information 15 into the first memory 6, without particular limitation, for example, the first information 15 can be inputted through a line such as a network connecting the first information source 21 with the first memory 6, or for example, the first information 15 can be inputted into the second memory 7 after going through communication means such as facsimiles, e-mails, and posts from the first information source 21.

Separately, the second information 16 is inputted from the second information source 22 into the second memory 7. The second information 16 can be inputted into the second memory 7 in the same manner as the input method of the first information 15 into the first memory 6.

Next, the first CPU 8 reads the first information 15 stored in the first memory 6 and the second information 16 stored in the second memory 7, and then in accordance with the predetermined programmed processing, determines the production conditions for the encapsulating layer 12 as the third information 17 (to be described next) based on the first information 15 and the second information 16.

### 2. Production management step

Thereafter, the third information 17 determined by the first CPU 8 is recorded in the fifth memory 10, and then the third information 17 recorded in the fifth memory 10 is inputted into the third memory 23.

The third information 17 can be inputted into the third memory 23 in the same manner as the input method of the first information 15 into the first memory 6.

Separately, the fourth information 18 is inputted from the first information source 21 and the second information source 22 into the fourth memory 24. The fourth information 18 can be inputted into the fourth memory 24 in the same manner as the input method of the first information 15 into the first memory 6.

Thereafter, the second CPU 25 reads the third information 17 stored in the third memory 23, and then in accordance with the predetermined programmed processing, the production conditions for the varnish production step S 1 and the production conditions for the encapsulating layer production step S2 are managed based on the third information 17.

Then, in the encapsulating layer production device 34, based on the production conditions managed by the second CPU 25, the varnish production step S 1 and the encapsulating layer production step S2 are sequentially performed.

### 3. Varnish production step S1

In the varnish production device 33, first, the varnish production step S1 is performed in accordance with the production conditions managed by the second CPU 25.

To be specific, in the varnish production step S1, first, the particles and the curable resin are prepared, and they are mixed to prepare a varnish 11 as a particle-containing curable resin composition.

The particles are selected, for example, from the above-described examples, and to be specific, selected from a phosphor and a filler.

The phosphor shape is selected from the examples shown above. The average value of the maximum length (when spherical, average particle size) of the phosphor is selected from the range shown as examples above. The absorption peak wavelength of the phosphor is selected from the range shown as examples above. The mixing ratio of the phosphor is selected from the range shown as examples above.

The filler is selected from the examples shown above. The average value of the maximum length (when spherical, average particle size) of the filler is selected from the range shown as examples above. The mixing ratio of the filler is selected from the range shown as examples above.

The curable resin is selected from the examples shown above. The viscosity of the one-step curable resin in A-stage is selected from the range shown as examples above. The mixing ratio of the curable resin is selected from the range shown as examples above.

To prepare the particle-containing curable resin composition, to be specific, as shown in FIG. 2, in the varnish production device 33, the above-described components are blended in a vessel 52 based on the production conditions for the varnish production step S1 managed by the second CPU 25. For example, the types of the varnish 11 managed by the second CPU 25, to be more specific, the types of the particles, the mixing ratio of the particles, the average value of the maximum length (when the particles are spherical, average particle size) of the particles, the types of the curable resin, the viscosity of the curable resin, the mixing ratio of the curable resin, and when the particles contain a phosphor, the absorption peak wavelength of the phosphor, and the viscosity of the varnish 11 managed by the second CPU 25. Then, they are mixed using a mixer 51.

In this manner, a varnish 11 in A-stage is prepared.

The viscosity of the varnish 11 at 25°C and under 1 atmospheric pressure is adjusted to be in the above-described range.

### 4. Encapsulating layer production step S2

In the application device 31, after the varnish production step S1, the encapsulating layer production step S2 is performed in accordance with the production conditions managed by the second CPU 25.

That is, the encapsulating layer 12 is prepared from the varnish 11.

To produce the encapsulating layer 12, for example, first, the varnish 11 is applied on the surface of the release sheet 28.

The release sheet 28 is selected from the examples shown above. The shape of the release sheet 28 is not particularly limited, and is selected from, for example, a generally rectangular shape (including oblong, elongated strips) when viewed from the top. Furthermore, for the release sheet 28, presence or absence of the formation of the positioning mark (not shown), and also the position information and size of the positioning mark are selected. The mark is formed so as to secure the region where the varnish 11 is applied.

The application device 31 that applies the varnish 11 on the release sheet 28 is selected, for example, from a dispenser, an applicator, and a slit die coater. Preferably, a dispenser is selected.

The application conditions for the varnish 11 are selected so that the thickness of the encapsulating layer 12 is in the above-described range.

That is, the application conditions for the application device 31 are selected such that the varnish 11 is adjusted, from the production conditions managed by the second CPU 25, to be specific, the shape of the varnish 11 immediately after application, and the thickness of the varnish 11 immediately after application managed by the second CPU 25.

When the release sheet 28 is formed with the positioning mark (not shown), a sensor (not shown) provided in the application device 31 adjusts the relative position of the varnish 11 relative to the positioning mark while checking the application position relative to the positioning mark.

Thereafter, when the varnish 11 contains a solvent, the varnish 11 is dried. To be specific, the varnish 11 is heated. The heating conditions are selected from the range shown as examples above.

In this manner, the encapsulating layer 12 provided on the surface of the release sheet 28 is produced.

### 5. Encapsulation step S3

In the lamination device 35 of the encapsulation device 32, the encapsulation step S3 is performed in accordance with the conditions controlled by the encapsulation control device 36 after the encapsulating layer production step S2.

To be specific, in the encapsulation step S3, first, the board 14 on which the optical semiconductor element 13 is mounted is prepared.

The board 14 is selected from the examples shown above. The outline shape of the board 14 is selected from the examples shown above. The size of the board 14 is selected from the examples shown above.

The optical semiconductor element 13 is selected from the examples shown above. The size of the optical semiconductor element 13 is selected from the range shown as examples above. The emission peak wavelength of the optical semiconductor element 13 is selected from the range shown as examples above.

The optical semiconductor element 13 is, for example, flip chip mounted, or connected by wire bonding on the board 14.

A plurality of the optical semiconductor elements 13 can be mounted on one board 14 (three in FIG. 1A-FIG. 1C). The number of the optical semiconductor element 13 per one board 14 is selected from the range shown as examples above.

Next, in this method, the board 14 on which the optical semiconductor element 13 is mounted is placed on the lamination device 35. The lamination device 35 is selected from the examples shown above. The board 14 on which the optical semiconductor element 13 is mounted is placed in the lamination device 35 in the same manner as described in examples shown above.

Then, the optical semiconductor element 13 is covered with the encapsulating layer 12. The optical semiconductor element 13 is covered with the encapsulating layer 12 in the same manner as described in examples shown above.

Thereafter, the encapsulating layer 12 in A-stage is brought into C-stage.

For example, the A-stage encapsulating layer 12 is brought into C-stage based on the heating conditions and the active energy ray application conditions for the encapsulating layer 12 to be brought into C-stage controlled by the encapsulation control device 36.

To be specific, when the one-step curable resin is selected from a thermosetting resin, the A-stage encapsulating layer 12 is heated.

To be specific, the lamination device 35 is introduced into an oven while the encapsulating layer 12 is sandwiched by the flat plates 41. In this manner, the A-stage encapsulating layer 12 is heated.

The heating temperature is selected from the range shown as examples above. The heating time is selected from the range shown as examples above.

The heating of the encapsulating layer 12 brings the stage of the encapsulating layer 12 into C-stage (completely cured) from A-stage.

In this manner, the optical semiconductor device 20 including the encapsulating layer 12, the optical semiconductor element 13 encapsulated with the encapsulating layer 12, and the board 14 on which the optical semiconductor element 13 is mounted is produced.

Thereafter, as shown in FIG. 1C, the release sheet 28 is removed from the encapsulating layer 12 as shown in the arrow.

### 6. Accumulation of production conditions, changes in lot and production amount per unit period

In the previous production of the encapsulating layer 12, the production conditions for the varnish production step S 1 and the production conditions for the encapsulating layer production step S2 are recorded and accumulated in the recording region (not shown) of the fifth memory 10.

That is, the fifth memory 10 inputs the third information 17 into the third memory 23, and at the same time, the third information 17 is accumulated, as fifth information 19 of past information, in the recording region of the fifth memory 10 as is.

Then, based on the current production of the encapsulating layer 12, the first CPU 8 reads the production conditions for the varnish production step S 1 and the production conditions for the encapsulating layer production step S2 accumulated in the fifth memory 10 of the previous production of the encapsulating layer 12, and based on such information, determines the production conditions for the varnish production step S 1 and the production conditions for the encapsulating layer production step S2 for the current production.

The lot information of at least one of particles, a curable resin, a varnish, and an optical semiconductor element, and/or the production amount of the optical semiconductor device 20 per unit period change. Depending on the changes, such fourth information 18 is inputted from the first information source 21 and the second information source 22 into the fourth memory 24, and then, the second CPU 25 reads the fourth information 18 stored in the fourth memory 24, and the production conditions for the varnish production step S1 and/or the production conditions for the encapsulating layer production step S2 are modified in accordance with the predetermined programmed processing.

### [Operations and effects of system]

In the system 1, the production condition determination device 2 includes the first memory 6, the second memory 7, and the first CPU 8; and the encapsulating layer production management device 3 includes the third memory 23 and the second CPU 25.

The production condition determination device 2 stores the first information 15 and the second information 16 in the first memory 6 and the second memory 7, respectively, and the first CPU 8 determines the production conditions for the encapsulating layer production step S2 and provides the production conditions to the encapsulating layer production management device 3.

Then, in the encapsulating layer production management device 3, the third information 17 relating to the production conditions provided from the production condition determination device 2 is stored in the third memory 23, and based on the third information 17, the second CPU 25 manages the production conditions for the encapsulating layer production step S2.

Thus, the production conditions for the encapsulating layer production step S2 can be determined in the production condition determination device 2 separately from the encapsulating layer production management device 3, and can be managed by the encapsulating layer production management device 3.

The third information 17 relating to the production conditions for the encapsulating layer production step S2 provided from the production condition determination device 2 is based on the first information 15 and the second information 16. Therefore, the encapsulating layer production management device 3 can manage the production conditions for the encapsulating layer production step S2 by the second CPU 25 based on the third information 17 provided from the production condition determination device 2. Thus, precise production of the target optical semiconductor device 20 can be achieved.

Furthermore, in the system 1, the first CPU 8 further determines the production conditions for the varnish production step S1 based on the first information 15 stored in the first memory 6, and the second information 16 stored in the second memory 7, and the second CPU 25 further manages the production conditions for the varnish production step S1 based on the third information 17 stored in the third memory 23. Therefore, precise production of an encapsulating layer 12 compatible to the target optical semiconductor device 20 can be achieved, and furthermore, precise production of a target optical semiconductor device 20 can be achieved.

Furthermore, in the system 1, the first information 15 contains information relating to the board 14 on which the optical semiconductor element 13 is mounted, and therefore the production condition determination device 2 can include the information relating to a board 14 on which the optical semiconductor element 13 is mounted, along with the information relating to the optical semiconductor element 13, and the information relating to the optical semiconductor device 20.

Therefore, based on highly precise third information 17 relating to the production conditions for the encapsulating layer production step S2 determined based the first information 15, the encapsulating layer production management device 3 can manage the production conditions for the encapsulating layer production step S2 further precisely.

Furthermore, in the system 1, the second CPU 25 can modify the production conditions for the encapsulating layer production step S2 based on the fourth information 18 stored in the fourth memory 24 containing lot information of at least one of particles, a curable resin, a varnish, and an optical semiconductor element 13, and/or a production amount of the optical semiconductor device 20 per unit period, in the encapsulating layer production management device 3. Therefore, responding easily to the changes in the lot information and/or the production amount of the optical semiconductor device 20, the production conditions for the varnish production step S1, and the production conditions for the encapsulating layer production step S2 are modified, and precise production of a target optical semiconductor device 20 can be achieved.

Furthermore, with the system 1, the fifth memory 10 of the production condition determination device 2 can accumulate the fifth information 19 relating to the production conditions in previous production of the encapsulating layer 12. Therefore, an encapsulating layer 12 compatible to a target optical semiconductor device 20 can be currently produced based on the production conditions accumulated in the past, and furthermore, a target optical semiconductor device 20 can be currently produced with precision.

With the system, because the production condition determination device 2 can be remotely communicated through a network with the encapsulating layer production management device 3, even if the production condition determination device 2 is remotely located from the encapsulating layer production management device 3, the production conditions for the encapsulating layer production step S2 determined in the production condition determination device 2 can be quickly provided to the encapsulating layer production management device 3.

Furthermore, with the system 1, even if the encapsulating layer production management device 3 is provided in the encapsulating layer production device 34 of the optical semiconductor device production factory 4, and the production condition determination device 2 is provided in the control section 5 located far from the encapsulating layer production device 34, the production condition determination device 2 can be remotely communicated with the sheet production management device 3 through a network, and therefore the production conditions for the sheet production step S2 determined in the production condition determination device 2 can be quickly provided to the sheet production management device 3.

The production condition determination device 2 includes a first memory 6, a second memory 7, and the first CPU 8.

Therefore, with the production condition determination device 2, the first information 15 and the second information 16 can be stored in the first memory 6 and the second memory 7, respectively, and the first CPU 8 can determine the production conditions for the varnish production step S1, and the production conditions for the encapsulating layer production step S2.

Thus, based on the production conditions for the varnish production step S1, and the production conditions for the encapsulating layer production step S2, precise production of a target optical semiconductor device 20 can be achieved.

Furthermore, in the production condition determination device 2, the second CPU 25 further determines the production conditions for the varnish production step S1, and the production conditions for the encapsulating layer production step S2, based on the first information 15 stored in the first memory 6, and the second information 16 stored in the second memory 7. Therefore, precise production of an encapsulating layer 12 compatible to the target optical semiconductor device 20 can be achieved, and furthermore, precise production of a target optical semiconductor device 20 can be achieved.

Furthermore, with the production condition determination device 2, the first information 15 contains information relating to a board 14 on which the optical semiconductor element 13 is mounted, and therefore the production condition determination device 2 can also contain the information relating to a board 14 on which the optical semiconductor element 13 is mounted, along with the information relating to the optical semiconductor clement 13, and the information relating to the optical semiconductor device 20.

Therefore, highly precise production of a target optical semiconductor device 20 can be achieved.

With the production condition determination device 2, the fifth information 19 relating to the production conditions in previous production of the encapsulating layer 12 can be accumulated. Therefore, an encapsulating layer 12 compatible to a target optical semiconductor device 20 can be currently produced based on the production conditions accumulated in the past, and furthermore, a target optical semiconductor device 20 can be currently produced with precision.

With the encapsulating layer production management device 3, the third information 17 containing production conditions for the varnish production step S 1 and the production conditions for the encapsulating layer production step S2 are stored in the third memory 23, and based on the third information 17, the second CPU 25 can precisely manage the production conditions for the varnish production step S 1, and the production conditions for the encapsulating layer production step S2.

Therefore, precise production of a target optical semiconductor device 20 can be achieved.

With the encapsulating layer production management device 3, the second CPU 25 further manages the production conditions for the varnish production step S 1, and the production conditions for the encapsulating layer production step S2, based on the third information 17 stored in the third memory 23, and therefore highly precise production of the encapsulating layer 12 compatible with the target optical semiconductor device 20 can be achieved, and furthermore, precise production of a target optical semiconductor device 20 can be achieved.

Furthermore, in the encapsulating layer production management device 3, the second CPU 25 can modify production conditions for the varnish production step S 1, and production conditions for the encapsulating layer production step S2, based on the fourth information 18 containing lot information of at least one of particles, a curable resin, a varnish, and an optical semiconductor element, and/or a production amount of the optical semiconductor device 20 per unit period stored in the fourth memory 24. Therefore, easily responding to the changes in the lot information and/or production amount of the optical semiconductor device 20, the production conditions relating to the varnish production step S 1 and the production conditions for the encapsulating layer production step S2 are modified, and precise production of a target optical semiconductor device 20 can be achieved.

### [Variation]

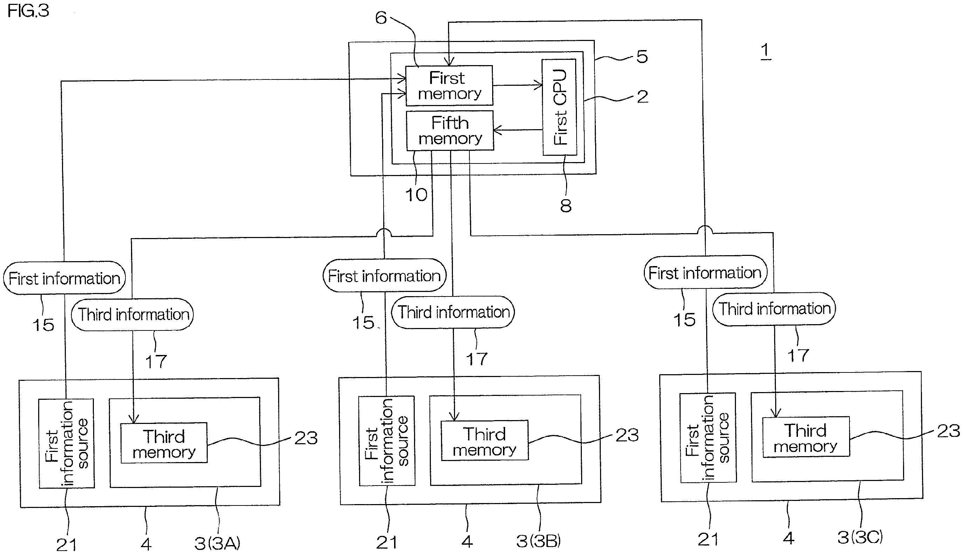

In description for FIG. 3, those members that are the same as those in FIG. 2 are given the same reference numerals, and detailed descriptions thereof are omitted.

In the embodiment of FIG. 2, the production condition determination device 2 and the encapsulating layer production management device 3 are in one-to-one correspondence, that is, one production condition determination device 2 is provided with one encapsulating layer production management device 3. However, the correspondence between the production condition determination device 2 and the encapsulating layer production management device 3 is not limited thereto, and for example, as shown in FIG. 3, one production condition determination device 2 can correspond with a plurality of encapsulating layer production management devices 3.

To be specific, each of the plurality of the independently provided optical semiconductor device production factories 4 includes an encapsulating layer production management device 3. The production condition determination device 2 and the plurality of encapsulating layer production management devices 3 are configured such that the plurality of sets of the first information 15 can be inputted through the respective first information sources 21 of the encapsulating layer production management devices 3 into the first memory 6, and the third information 17 determined by the first CPU 8 can be inputted through the fifth memory 10 into the plurality of third memories 23.

In the embodiment of FIG. 3, one production condition determination device 2 provides the third information 17 into one encapsulating layer production management device 3A (3), and the first information 15 is obtained from the first information source 21 of the one encapsulating layer production management device 3A (3) and stored in the first memory 6, and the first information 15 is accumulated in the fifth memory 10, and can be provided to other encapsulating layer production management device 3B (or a plurality of other encapsulating layer production management devices 3B and 3C)(3).

That is, one production condition determination device 2 can centralize the plurality of sets of first information 15 (the first information 15 to be stored in the first memory 6, to be specific, information relating to the optical semiconductor element 13, information relating to the board 14, and information relating to the optical semiconductor device 20) provided from the plurality of encapsulating layer production management devices 3. That is, one production condition determination device 2 can function as a centralized production condition determination device 2 that can centralize the first information 15 from the plurality of encapsulating layer production management devices 3 and provide the third information 17 corresponding to the plurality of encapsulating layer production management devices 3.

Therefore, with one production condition determination device 2, highly precise third information 17 can be provided to each of the encapsulating layer production management devices 3.

Furthermore, in the embodiment of FIG. 2, the system 1 determines and manages the production step of the varnish production step S 1. That is, the encapsulating layer production management device 3 manages the production conditions for the varnish production step S1. However, the configuration of the system 1 can be made such that the system 1 does not determine and manage the production step of the varnish production step S1. To be specific, the configuration can be made such that only the production conditions for the encapsulating layer production step S2 are managed without managing the production conditions for the varnish production step S 1.

In this embodiment, the second CPU 25 does not have to manage the production conditions for the varnish production step S 1, and therefore the configuration of the second CPU 25 can be made simple.

Furthermore, in the embodiment of FIG. 2, as a production management device of the present invention, the encapsulating layer production management device 3 manages the production conditions for the encapsulating layer production step S2, and the encapsulation control device 36 manages the encapsulation conditions for the encapsulation step S3. However, for example, the encapsulating layer production management device 3 can also work as the encapsulation control device 36 to configure one production management device, and can manage both of the production conditions for the encapsulating layer production step S2 and the encapsulation conditions for the encapsulation step S3.

Furthermore, in the embodiments of FIG. 2 and FIG.3, the encapsulating layer 12 is selected as the phosphor layer (phosphor-containing encapsulating layer), but for example, although not shown, it can be selected as an encapsulating layer (resin layer) 12 containing no phosphor.

Furthermore, in the description for FIG. 2, the first information 15 contains the information relating to a board 14 on which the optical semiconductor element 13 is mounted. However, the first information 15 can be configured such that it contains no first information 15.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The system, the production condition determination device, and the production management device are used for production of an optical semiconductor device.

### Description of Reference Numerals

- 1: SYSTEM
- 2: PRODUCTION CONDITION DETERMINATION DEVICE
- 3: SHEET PRODUCTION MANAGEMENT DEVICE
- 6: FIRST MEMORY
- 8: FIRST CPU
- 11: VARNISH
- 12: ENCAPSULATING LAYER
- 13: OPTICAL SEMICONDUCTOR ELEMENT
- 14: BOARD
- 15: FIRST INFORMATION
- 16: SECOND INFORMATION
- 17: THIRD INFORMATION
- 20: OPTICAL SEMICONDUCTOR DEVICE
- 23: THIRD MEMORY
- 24: FOURTH MEMORY
- 50: COVER LAYER
- S1: VARNISH PRODUCTION STEP
- S2: COVER LAYER PRODUCTION STEP
- S3: ENCAPSULATION STEP

## Claims

1. A method for producing an optical semiconductor device, the method comprising the steps of:
a varnish production step of producing a varnish containing particles and a curable resin,
a cover layer production step of producing an A-stage cover layer from the varnish, and
a covering step of covering the optical semiconductor element with the A-stage covering layer.

2. A system for determining and managing a production condition for a cover layer production step in a method for producing an optical semiconductor device including a varnish production step of producing a varnish containing particles and a curable resin, a cover layer production step of producing an A-stage cover layer from the varnish, and the covering step of covering the optical semiconductor element with the A-stage covering layer,
wherein the system includes a production condition determination device and a production management device,
the production condition determination device includes
a first information storage region in which first information relating to an optical semiconductor element and an optical semiconductor device is stored,
a second information storage region in which second information relating to a varnish is stored, and
a determination means that determines the production condition based on the first information stored in the first information storage region and the second information stored in the second information storage region,
the production management device includes
a third information storage region in which third information relating to the production conditions determined by the determination means is stored, and
a management means for managing the production condition for the cover layer production step based on the third information stored in the third information storage region.

3. The system according to Claim 2, wherein the system further determines and manages a production condition for the varnish production step, and
the determination means further determines the production condition for the varnish production step based on the first information stored in the first information storage region and the second information stored in the second information storage region, and
the management means further manages the production condition for the varnish production step based on the third information stored in the third information storage region.

4. The system according to Claim 2, wherein the first information contains information relating to a board on which an optical semiconductor element is mounted.

5. The system according to Claim 2, wherein the production management device comprises
a fourth information storage region in which fourth information is stored, the fourth information containing lot information of at least one of particles, a curable resin, a varnish, and an optical semiconductor element, and/or a production amount of the optical semiconductor device per unit period, and
a modification means that modifies the production condition for the cover layer production step based on the fourth information stored in the fourth information storage region.

6. The system according to Claim 2, wherein the production condition determination device comprises
a fifth information storage region in which fifth information relating to production conditions for previous production of the cover layer is stored, and
determines the production condition for current production of the cover layer based on the fifth information stored in the fifth information storage region.

7. The system according to Claim 2, wherein the production condition determination device remotely communicates with the production management device through a network.

8. The system according to Claim 7, wherein the production management device is provided in a cover layer production factory, and
the production condition determination device is provided in a control section located far from the cover layer production factory.

9. A production condition determination device for determining the production condition for the cover layer production step in a method for producing an optical semiconductor device including a varnish production step of producing a varnish containing particles and a curable resin, a cover layer production step of producing an A-stage cover layer from the varnish, and a covering step of covering the optical semiconductor element with the A-stage covering layer,
wherein the production condition determination device comprises a first information storage region in which the first information relating to the optical semiconductor element is stored,
a second information storage region in which second information relating to the varnish is stored, and
a determination means that determines the production condition based on the first information stored in the first information storage region and the second information stored in the second information storage region.

10. The production condition determination device according to Claim 9, wherein the production condition determination device further determines the production condition for the varnish production step, and
the determination means further determines the production condition for the varnish production step based on the first information stored in the first information storage region and the second information stored in the second information storage region.

11. The production condition determination device according to Claim 9, wherein the first information contains the information relating to the board on which an optical semiconductor element is mounted.

12. The production condition determination device according to Claim 9, further comprising a fifth information storage region in which fifth information relating to production conditions for previous production of the cover layer is stored,
wherein the production condition determination device determines the production condition for current production of the cover layer based on the fifth information stored in the fifth information storage region.

13. A production management device for managing a production condition for the cover layer production step in a method for producing an optical semiconductor device including a varnish production step of producing a varnish containing particles and a curable resin, a cover layer production step of producing an A-stage cover layer from the varnish, and a covering step of covering the optical semiconductor element with the A-stage covering layer,
wherein the production management device includes a third information storage region in which third information relating to the production conditions is stored,
and a management means that manages the production condition for the cover layer production step based on the third information stored in the third information storage region.

14. The production management device according to Claim 13, wherein the production management device manages the production condition for the varnish production step, and
the management means further manages the production condition for the varnish production step based on the third information stored in the third information storage region.

15. The production management device according to Claim 13, comprising a fourth information storage region in which the fourth information containing lot information of at least one of particles, a curable resin, a varnish, and an optical semiconductor element, and/or a production amount of the optical semiconductor device per unit period is stored, and
a modification means that modifies the production condition for the cover layer production step based on the fourth information stored in the fourth information storage region.
